(19) Europäisches Patentamt
European Patent Office
Office européen des brevets

(11) **EP 2 224 797 A1**

(12) **EUROPEAN PATENT APPLICATION**
published in accordance with Art. 153(4) EPC

(43) Date of publication:
**01.09.2010 Bulletin 2010/35**

(51) Int Cl.:
*H05K 3/38* *(2006.01)*    *H05K 3/12* *(2006.01)*
*H05K 3/18* *(2006.01)*

(21) Application number: **08848612.1**

(22) Date of filing: **11.11.2008**

(86) International application number:
**PCT/JP2008/070530**

(87) International publication number:
**WO 2009/063883 (22.05.2009 Gazette 2009/21)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **13.11.2007 JP 2007293873**

(71) Applicant: **Seiren Co., Ltd.**
**Fukui-shi**
**Fukui 918-8560 (JP)**

(72) Inventors:
• **TSUBOTA, Masanori**
  **Fukui-shi**
  **Fukui 918-8560 (JP)**
• **SHIOMI, Hidekazu**
  **Fukui-shi**
  **Fukui 918-8560 (JP)**
• **OGATA, Hiroshi**
  **Fukui-shi**
  **Fukui 918-8560 (JP)**

(74) Representative: **HOFFMANN EITLE**
**Patent- und Rechtsanwälte**
**Arabellastrasse 4**
**81925 München (DE)**

(54) **METHOD FOR FORMING ELECROCONDUCTIVE THIN LINE**

(57)    The object underlying the present invention is the provision of a method for forming a high-definition electroconductive thin line free from blurring at low cost. This is accomplished by a method for forming an electroconductive thin line on the surface of a resin base material comprising the following steps: A resin film having a hardness of 20 to 70, as measured by a type A measuring method specified in JIS K 6253, is formed on a surface of a resin base material. A thin line pattern is formed on the resin film by intaglio printing or stencil printing, preferably using an electroconductive paste. In the alternative, an electroless plating catalyst ink can be used. Subsequently, a metal film can be formed on the thin line pattern by plating to form an electroconductive thin line.

EP 2 224 797 A1

## Description

## Technical Field

The present invention relates to a method for forming an electroconductive thin line having an electromagnetic shielding ability, which is used for electronic circuits and electronic parts, on the surface of a resin base material. More precisely, the present invention relates to a method for forming a thigh-definition electroconductive thin line free from blurring at low cost.

## Background Art

On the surfaces of electronic circuits and electronic parts, in order to avoid various types of problems caused by electromagnetic waves radiated therefrom, it is necessary to apply a plate-like or film-like electroconductive member having an electromagnetic shielding ability.

As a method for producing an electroconductive member having an electromagnetic shielding ability, a method of forming a transparent electroconductive membrane on a base material, a method of forming an electroconductive thin line on a base material in a net-like form or a lattice-like form, or the like have been proposed.

In the case that an electroconductive member having an electromagnetic shielding ability is produced by forming a net-like or lattice -like electroconductive thin line on a base material, in order to obtain a high electromagnetic shielding ability, it is necessary to form an electroconductive thin line which is as fine as possible with a high degree of accuracy, with exactness and with high density.

As a method for forming a fine electroconductive thin line like this on a base material, a method of printing an electroconductive thin line on a base material by a screen printing method using an electroconductive paste is proposed. However, when the adhesiveness between a pattern layer formed by screen printing and a base material is low to form a space, blurring would arise caused by the electroconductive paste entered into the space, and printing precision of the thin line would be deteriorated.

As a method for improving the printing accuracy of an electroconductive thin line by screen printing, a method of producing a screen printing plate wherein the smoothness of the surface of a resin film is increased (see Patent Document 1). This method, however, has such defects that it needs high production cost and is unable to be compatible with a tendency to make a large area with ease, since the process for producing the plate becomes complex.

It is also proposed a method wherein a particular kind of substrate film containing a resin soluble in the ink solvent or absorbable of said solvent is formed on the printing surface of a material to be printed prior to screen printing (see Patent Document 2). However, since spreading of the ink is quicker than absorbing of the ink, it has a defect that blurring would occur.

As mentioned above, it is not easy to form a net-like or a lattice-like electroconductive thin line with a high-definition state, and it is desired to develop a method for forming a high-definition thin line in a convenient manner at low cost.

Patent Document 1: Jpn. Pat. Laid-Open Publication No. 2004-325552
Patent Document 2: Jpn. Pat. Laid-Open Publication No. 2003-145709

## Disclosure of the Invention

## Problems to be Solved by the Invention

The problem to be solved by the present invention is to provide a method for forming a high-definition electroconductive thin line free from blurring at low cost.

## Means for Solving the Problems

The inventors of the present invention paid intensive efforts to dissolve the above-mentioned problems and, as a result, they found that an electroconductive thin line free from blurring can be formed by forming in advance a resin film having a hardness in a specific range, i.e. a layer having a moderate cushioning property, on a surface of a resin base material, and subsequently forming a thin line pattern by using an electroconductive paste or by electroless plating thereon, and thus completed the present invention.

Thus, the present invention relates to a method for forming an electroconductive thin line shown (1)-(7) below.

(1) A method for forming an electroconductive thin line on the surface of a resin base material which comprises at least the following steps (a) and (b):

(a) a step of forming a resin film having a hardness of 20 to 70, as measured by a type A measuring method specified in JIS-K-6253 on the surface of a resin base material (a resin film-forming step),
(b) a step of forming a thin line pattern on the resin film by intaglio printing or stencil printing (a thin line pattern-forming step).

(2) The method for forming an electroconductive thin line according to (1), wherein said step (b) is a step of forming a thin line pattern on the resin film using an electroconductive paste by intaglio printing or stencil printing.

(3) The method for forming an electroconductive thin line according to (1), wherein said step (b) is a step of forming a thin line pattern on the resin film using an electroless plating catalyst ink by intaglio printing or stencil printing, and subsequently forming a metal layer on the thin line pattern by plating.
(4) The method for forming an electroconductive thin line according to (1) to (3), wherein said resin film has voids in its inside.

(5) The method for forming an electroconductive thin line according to (4), wherein a void ratio of said resin film is 10 to 40%.
(6) The method for forming an electroconductive thin line according to (1) to (5), wherein said resin film comprises fine particles having a particle diameter of 10 to 200nm.

(7) The method for forming an electroconductive thin line according to (1) to (6), wherein said resin film is insoluble in a solvent used for an electroconductive paste or an electroless plating catalyst ink.

**Effects of the Invention**

According to the present invention, by forming a resin film having a hardness in a specific range, i.e. a layer having a moderate cushioning property, on a surface of a resin base material, and subsequently forming a thin line pattern by screen printing or the like, the pattern layer can be closely adhered to the resin film which can prevent the line from blurring caused by running off the printing ink from the pattern. Therefore, a finer electroconductive thin line can be formed with a high degree of accuracy.

**Best Made for Carrying Out the Invention**

The method of forming an electroconductive thin line is **characterized in that** it comprises at least the following steps (a) and (b).

(a) a step of forming a resin film having a hardness of 20 to 70, as measured by a type A measuring method specified in JIS-K-6253 on the surface of a resin base material (a resin film-forming step)
(b) a step of forming a thin line pattern on the resin film (a thin line pattern-forming step)

1. Step (a): Resin Film-Forming Step

In the step (a) of the present invention, a resin film is formed on a resin base material.

(1) Resin Base Material

As the resin base materials to be used for the present invention, one or more than one of insulating resins selected from the group consisting of an epoxy resin, an epoxy acrylate resin, an urethane acrylate resin, a polyester resin (more precisely, polyethylene terephthalate), a phenol resin, a polyimide resin, a bismaleimide triazine resin, a polyphenylene ether resin, a fluorine resin, a benzocyclobutene resin, and a liquid crystal polymer (more precisely, an aromatic polyester resin) or the like can be used. The insulating resins can also be a thermosetting resin or a photosensitive resin. Among them, it is particularly preferable to use a polyester resin (polyethylene terephthalate).

The above-mentioned insulating resin can be laminated on its any side with a glass cloth, a glass nonwoven cloth, an aramid nonwoven cloth, an aramid film, a polyimide film or the like as a reinforcing material in order to improve a strength of the base material.

While the thickness of the resin base material is not particularly limited, it is preferably 25 to 500$\mu$m, more preferably 75 to 250$\mu$m. In the case of laminating a reinforcing material, while the thickness of the reinforcing material is not particularly limited, it is preferably 25 to 500$\mu$m, more preferably 35 to 65$\mu$m.

(2) Resin Film

The resin film formed on the surface of the resin base material according to the present invention is required to have a hardness of 20 to 70, as measured by a type A measuring method specified in JIS-K-6253. That is, according to the present invention, a thin line pattern is not formed directly on the surface of the resin base material, but a resin film having a moderate cushioning property is formed on the surface of the resin base material and then a thin line pattern is formed thereon. Accordingly, a high-definition electroconductive thin line free from blurring can be formed in a convenient manner at low cost. When the hardness of the resin film is less than the above range, the film strength may be deteriorated. When the hardness thereof is more than the above range, the line width of the printing pattern may not be so fine.

(i) Void Ratio

Examples of the preferable methods for forming a resin film which fulfills the above-mentioned requirement of hardness include a method of forming a specific amount of voids in its inside. While the void ratio is not particularly limited, it is preferably 10 to 40%, more preferably 15 to 35%. When the void ratio is too low, the resin film may be too hard. When the void ratio is too high, the hardness may become insufficient.

While a specific method for forming voids inside is not particularly limited, examples thereof include a method of dissolving a resin film-forming material in a mixed solution of two organic solvents having different boiling points with each other and water, and then drying the solution in multiple steps with different conditions. Accordingly, the resin film-forming material is dispersed inhomogeneously, and in the meantime, a resin film having voids can be formed. In addition, it is also possible to employ a method of forming a resin film having a given amount of voids by using a resin film-forming material which is a mixture of a resin and a specific amount of fine particles, and by drying drastically after coating said resin film-forming material.

(ii) Resin Film-Forming Material

Examples of resins which can form a resin film having the above-mentioned hardness (a resin film-forming material) include a resin which can form a resin film having the above-mentioned hardness by forming voids by drying in multiple steps or the like and a composite material which is a mixture of a resin and fine particles and is able to form a resin film having the above-mentioned hardness by forming desired voids by drying drastically.

Examples of the resins for the resin film-forming material include a polyurethane resin, an acrylic resin, an ethylene/vinyl acetate copolymer resin, a polyethylene resin, a polypropylene resin, a carboxylated styrene/butadiene copolymer resin and a polyester resin, which are preferable in the case that the resin base material is a polyester resin. While the molecular weight thereof is not particularly limited, it is preferably 500 to 5000. These resins can be used each independently or more than one of them can be used in combination with each other. They can meet the above-mentioned conditions of hardness through the drying process in multiple steps after dissolving in a mixed solvent, without adding additives such as fine particles.

Among them, a polyurethane resin is preferable in terms of adhesiveness with a resin base material, cracking resistance, chemical resistance against a plating solution, and economic efficiency. While the molecular weight of the polyurethane resin is not particularly limited, it is preferably 500 to 5000.

Examples of organic solvents to dissolve the polyurethane resin include ketone-type solvents such as methylethylketone (MEK) and acetone, ether-type solvents such as tetrahydrofuran, aromatic solvents such as toluene and petroleum-derived solvents such as petroleum spirits. These solvents can be used each independently or more than one of them can be mixed with each other.

It is more preferable to use a mixed organic solvent by a combination of two organic solvents having different boiling points, one having a lower boiling point and one having a higher boiling point. In this case, the boiling point of the first organic solvent having a lower boiling point is preferably 50 to 100˚C, more preferably 60 to 80˚C. Examples of such organic solvents include ketone-type solvents and ether-type solvents. The boiling point of the second organic solvent having a higher boiling point is preferably not lower than 100˚C, more preferably 100 to 130˚C. Examples of such organic solvents include aromatic solvents and petroleum-derived solvents.

Among the combinations of the above-mentioned organic solvents, it is particularly preferable to use the combination of MEK and toluene to be hereinafter described.

The ratio of the first organic solvent and the second organic solvent in the mixed organic solvent is preferably [the first organic solvent] : [the second organic solvent] = 9:1 to 3:7 (ratio by weight).

Meanwhile, in the case of forming a resin film having the above-mentioned hardness by adding additives such as fine particles, it is preferable to use a hydrophilic resin as a resin for the resin film-forming material, since it is used by mixing with fine particles dispersed in water. Examples of the hydrophilic resins include polyvinylalcohol, cation-modified polyvinylalcohol, anion-modified polyvinylalcohol, silanol-modified polyvinylalcohol, polyvinyl butyral, gelatin, methyl cellulose, ethyl cellulose, hydroxyethyl cellulose, polyvinyl pyrrolidone and polyethyleneglycol. They can be used each independently, or more than one of them can be used by mixing with each other.

Among them, it is preferable to use polyvinylalcohol, silanol-modified polyvinylalcohol and polyvinyl butyral having a polymerization degree of 1000 to 2000 and a saponification degree of not less than 85% in terms of adhesiveness with a resin base material, cracking resistance, chemical resistance against a plating solution, and economic efficiency.

When the polymerization degree is less than 1000, the resin film strength may become insufficient. When the polymerization degree is more than 2000, coating stability may be deteriorated. When the saponification degree is less than 85%, the resin film strength may also become insufficient.

(iii) Fine Particles

As the fine particles to be used for the above-mentioned resin film-forming material, it is preferable to use inorganic fine particles. Examples of the inorganic fine particles include ceramic fine particles such as mica, talc, alumina, pseudo-boehmite, calcium carbonate, glass, silica, zeolite, kaolinite, zirconia, ceria and aluminosilicate. They can be used each independently, or more than one of them can be used in combination with each other. Among them, it is particularly preferable to use alumina and pseudo-boehmite in terms of durability and economic efficiency.

While the particle diameter thereof is not particularly limited, it is preferably 10 to 200nm, more preferably 25 to 100nm. When the particle diameter is less than 10nm, a sufficient amount of voids may not be obtained. When the particle diameter is more than 200nm, deterioration of the resin film strength and decrease in stability of a coating solution may be caused, and in addition, transparency of the resin film may be decreased and therefore, change in color of the base material may become a problem depending on the intended use.

In the case of blending fine particles, the ratio by weight of the above-mentioned hydrophilic resin and fine particles is preferably [the hydrophilic resin]: [fine particles] = 1:6 - 1:15. When the ratio of fine particles is too large, adhesiveness between fine particles may become poor and may be unable to obtain sufficient film strength because of a lack of the resin bonding the fine particles with each other. When the ratio of fine particles is too small, since the surplus resin would fill the space between the particles, the void ratio may be decreased, and it may cause unable to obtain a sufficient cushioning effect.

(iv) Other Additives

The resin film-forming material of the present invention can contain various kinds of known additives such as a surface adjuster, a cross-linking agent and the like, if necessary.

The surface adjuster is blended for the purpose of adjusting wetting characteristic of the resin solution with the base material and surface conditions of the resin film. Examples of the surface adjusters include an acetylene alcohol type surfactant, an acetylene glycol type surfactant, a silicone type surfactant and a fluorine type surfactant.

The cross-linking agent is blended for the purpose of improving strength of the resin film by cross-linking among the resin or by cross-linking between the resin and the fine particles to improve adhesiveness of the resin film. Examples of the cross-linking agents include diisocyanates and a block material thereof such as tolylene diisocyanate, diphenylmethane-4,4'-diisocyanate, hexamethylene diisocyanate and isophorone diisocyanate, amino resins such as an n-butylated melamine resin, an isobutylated melamine resin, a butylated urea resin and a butylated melamine-urea copolycondensation resin, epoxy resins such as a bisphenol A-type epoxy resin, a phenol/novolak-type epoxy resin and cresol/novolak-type epoxy resin, boric acid, glyoxal, and a coupling agent. Furthermore, examples of curing accelerators thereof include dibutyltin dilaurate, tertiary amines and salts thereof, polybasic acid anhydrides, imidazoles, dicyan diamide, melamine, benzoguanamine, methanesulfone and para-toluenesulfonic acid.

(3) Formation of Resin Film

The resin film can be formed by coating a coating solution, wherein necessary components is dissolved or dispersed, on a base material and by drying it. The method for coating can be selected from known methods such as a roll coater, a bar coater, a floating knife coater, a die coater, a gravure coater, a curtain cater, a blade coater, a spray coating and a dip coating.

In the case of forming a resin film not containing fine particles, a resin film which has desired voids and meets the conditions of hardness of the present invention can be formed by using a coating solution wherein a resin for the resin film-forming material is dissolved in a specific organic solvent and water to form a suspension liquid, and by carrying out drying treatment in multiple steps to the coated film after coating said coating solution.

Examples of the organic solvents include ketone-type solvents such as methylethylketone (MEK) and acetone, ether-type solvents such as tetrahydrofuran, aromatic solvents such as toluene and petroleum-derived solvents such as petroleum spirits. These solvents are used as a mixed organic solvent in combination with two solvents having different boiling points, one having a lower boiling point and one having a higher boiling point.

The boiling point of the organic solvent having a lower boiling point is preferably 50 to 100˚C, more preferably 60 to 80˚C. Examples of such organic solvents include ketone-type solvents and ether-type solvents.

The boiling point of the organic solvent having a higher boiling point is preferably not lower than 100˚C, more preferably 100 to 130˚C. Examples of such organic solvents include aromatic solvents and petroleum-derived solvents.

The ratio of the organic solvent having a lower boiling point and the organic solvent having a higher boiling point is preferably [the organic solvent having a lower boiling point]:[the organic solvent having a higher boiling point] = 9:1 to 3:7 (ratio by weight).

The particularly preferable combination for the mixed organic solvent is a combination of MEK and toluene.

In the mixed solvent which is a combination of the mixed organic solvent and water, the ratio of the mixed organic solvent and water is preferably [the mixed organic solvent] : [water] = 5:3 - 8:1 (ratio by weight).

While the ratio of the resin solid content (the resin concentration) in the coating solution is not particularly limited, in the case of using polyurethane as the resin, it is preferable to prepare a coating solution so as to contain 5 to 20% by weight of the solid content based upon the total weight of the coating solution.

In the case of forming a resin film not containing fine particles, it is preferable that the drying treatment in multiple steps to the coating film comprises, in particular, an initial drying process wherein the drying temperature is lower than 100˚C and not higher than the boiling point of the organic solvent A, and a late drying process wherein the drying temperature is not lower than 100˚C.

The preferable film-forming conditions of the resin film not containing fine particles are described below. In the following description, the term "the organic solvent A" means the organic solvent having a lower boiling point and the term "the organic solvent B" means the organic solvent having a higher boiling point out of the two organic solvents having the different boiling points.

<Conditions>

Preferable conditions for the initial drying process wherein the drying temperature is lower than 100˚C and not higher than the boiling point of the organic solvent A is as follows : drying temperature = 50˚C to 79.6˚C, time for drying = 30sec to 120sec. The organic solvent A having a lower boiling point such as MEK would be preferentially evaporated, and the resin dispersion solution coated on the base material would begin to undergo phase separation. More resin would be present in the organic solvent B such as toluene to generate an inhomogeneous coating state which is an initial state of forming voids.

Preferable conditions for the late drying process wherein the drying temperature is not lower than 100˚C is as follows: drying temperature = 100˚C to 130˚C, time for drying = 30sec to 120sec. While the phase-separated aqueous phase is repelled on the base material to develop forming of voids, water and the organic solvent B are evaporated to fix and stabilize the voids thus formed.

In the case of forming a resin film containing fine particles, the coating solution is the one wherein a hydrophilic resin and fine particles are dissolved or dispersed in water. While the ratio of the solid content (the hydrophilic resin and fine particles) in the coating solution is not particularly limited, it is preferably 5 to 20% by weight based upon the total weight of the coating solution.

After coating the above-mentioned coating solution, drastic drying at a high temperature to the coated film is carried out. More precisely, after coating the coating solution, the coated film is dried for 2 to 5 minutes at a high temperature of 100 to 150˚C, whereby a resin film having a hardness of 20 to 70 can be obtained. It is presumable that voids can be formed inside the resin film by evaporating water drastically at a high temperature from the coated film containing fine particles. When the time for drying is too long, hardening of the resin may proceed too far to make the hardness more than 70, and as a result, the line width of the printing pattern may not be high-definition. When the time for drying is too short, the film strength may be decreased.

While the thickness of the resin film thus obtained is not particularly limited, it is preferably 3 to 15$\mu$m, more preferably 5 to 10$\mu$m. When the thickness of the resin film is too low, the line width of the printing pattern may not be high-definition. When the thickness thereof is too high, the film strength may be decreased.

In addition, as will be described below, it is preferable that the resin film is insoluble in a solvent used for an electroconductive paste or an electroless plating catalyst ink. The resin films formed by using the above-mentioned resin film-forming materials are basically insoluble in such solvents.

2. Step (b): Thin Line Pattern-Forming Step

In the step (b), a thin line pattern is formed on the resin film which is formed in the step (a). Examples of the methods for forming a thin line patter include a method of forming a thin line pattern using an electroconductive paste by intaglio printing or stencil printing and a method of forming a thin line pattern using an electroless plating catalyst ink by intaglio printing or stencil printing and subsequently forming a metal layer on the thin line pattern by plating treatment.

(1) Formation of Thin Line Pattern Using Electroconductive Paste

In the case of forming a thin line pattern using an electroconductive paste, examples of the electroconductive pastes to be used include those ordinarily used in this field. It is most preferable that 40 to 95% by weight of electroconductivity-imparting particles such as carbon, gold, silver, copper, nickel and the like is comprised in a binder such as a polyester resin, an epoxy resin, an ethyl cellulose resin, an acrylic resin and the like to make a paste having a volume resistivity of $10 \times 10^{-3}$ to $10 \times 10^{0}\Omega\cdot$cm.

In addition, examples of solvents include terpineol, glycol ethers and glycol esters.

In the case of printing the thin line pattern using an electroconductive paste, intaglio printing or stencil printing is employed as a printing method. As for the intaglio printing, direct gravure printing using a gravure roll is preferable. Examples of the stencil printing include mimeographing printing and screen printing, and among them, screen printing is preferable.

(2) Formation of Thin Line Pattern by Electroless Plating Treatment

In the case of forming an electroconductive thin line by electroless plating treatment, firstly a thin line pattern is formed by using an electroless plating catalyst ink. The electroless plating catalyst ink is an ink containing an electroless plating catalyst component, and in general, a binder resin and a solvent are contained in addition to the electroless plating catalyst component.

(i) Electroless Plating Catalyst Component

Examples of the electroless plating catalyst components comprised in the above-mentioned electroless plating catalyst ink include colloid particles of noble metals such Pd, Au, Ag, PT and the like, fine particles of various kinds of metals such as Cu, Ni, Fe, Co and the like, chlorides thereof, sulfates thereof, nitrates thereof and ammonium salts thereof. Particularly, it is preferable to use Pd (palladium) in terms of a balance between catalytic ability and economic efficiency.

(ii) Binder Resin

The binder resin is blended for the purpose of imparting suitable viscosity to the electroless plating catalyst ink for its printing method and improving a bonding strength between the catalyst and the resin film. Examples of the binder resins include polyester resins, acrylic resins, vinyl resins such as vinyl acetate, vinyl chloride, PVA and PVB, ethyl cellulose resins, polyurethane resins, polyimide resins, polyamide resins, phenolic resins, phenoxy resins and alkyd resins. Among them, vinyl resins such as PVB and ethyl cellulose resins are particularly preferable.

(iii) Solvent

The solvent is blended for the purpose of dissolving the binder resin and giving the ink fluidity. It is possible to use one or an appropriate combination of more than one of the solvents having suitable drying characteristics for each printing method.

Examples of the solvents include water, alcohols such as methanol, ethanol and isopropyl alcohol, ketones such as acetone, methyl ethyl ketone, methyl isobutyl ketone and cyclohexanone, aromatic hydrocarbons such as toluene and xylene, polyalkylene glycols and the derivatives thereof such as ethyleneglycol, ethyleneglycol ethylether, ethyleneglycol butylether, diethyleneglycol, diethyleneglycol ethylether acetate, diethyleneglycol butylether acetate, propyleneglycol, propyleneglycol methylether, propyleneglycol methylether acetate and dipropyleneglycol methylether, acetic esters such as ethyl acetate and butyl acetate, $\gamma$-butyrolactone, N-methyl pyrrolidone, isophorone, dimethyl sulfoxide, dimethylformamide, terpineol and solvent naphtha. Among them, it is particularly preferable to use diethyleneglycol butylether acetate, ethyl acetate, methylethylketone and cyclohexanone.

As a solvent to be used for the electroconductive paste or the electroless plating catalyst ink, it is necessary to select a combination of solvents so as to be insoluble to the resin contained in the resin film. Insolubility described here means that the result of a peeling test based on the cross-cut method specified in JIS-K-5600-5-6 carried out after immersing the resin film formed on the resin base material in the solvent for 10 minutes and then drying well is not higher than 15%.

(iv) Printing Method

As the method for printing a thin line patter using an electroless plating catalyst ink, intaglio printing or stencil printing is employed. As for the intaglio printing, direct gravure printing using a gravure roll is preferable. Examples of the stencil printing include mimeographing printing and screen printing, and among them, screen printing is preferable.

(v) Plating Treatment

Examples of the electroless plating methods include usual methods using copper, nickel or alloys thereof. In addition, it is possible to change adhesiveness and/or color by improving adhesion strength with a material to be printed by heat treatment, blackening by oxidation or sulfuration and the like.

According to the present invention, it is possible to form another metal layer overlapped on the metal layer formed by the above-mentioned electroless plating, by electroplating or the like, if necessary. For the electroplating, metals normally employed such as copper, nickel and alloys thereof can be used. Furthermore, it is possible to change electroconductivity and/or color by additional electroless plating to improve electroconductivity, blackening these metal layers by oxidation or sulfuration, or the like.

(3) Thin Line Pattern

The pattern of the electroconductive thin line of the present invention can be formed of a stripe or a mesh. For examples, a mesh can be formed by combining more than one form such as polygon such as triangle, square, hexagon and octagon, circle or the like with each other.

The line width of the electroconductive thin line is preferably 5 to 50$\mu$m, and the space between a line and a line is preferably 100 to 700$\mu$m. In addition, a bias can be applied in order to eliminate moire. When the line width is less than 5$\mu$m, electroconductivity may be insufficient which may cause unable to shield electromagnetic wave sufficiently. When the line width is more than 50$\mu$m, transparency may be deteriorated. The space between a line and a line is less than 100$\mu$m, transparency may be deteriorated. When the space is more than 700$\mu$m, electroconductivity may be deteriorated.

The thickness of the electroconductive thin line is preferably 0.1 to 15$\mu$m, and the formula "$1 \leqq W/T \leqq 500$" is preferably fulfilled, wherein W is the width of the electroconductive thin line and T is the height of the electroconductive thin line, whereby contamination of bubbles can be prevented at the time of laminating with other base materials. When W/T is less than 1, transparency may be deteriorated because of contamination of bubbles at the time of laminating with other base materials. When W/T is more than 500, transparency may be deteriorated because of the electroconductive thin line itself and/or the electroconductive thin line may be peeled off easily.

**Examples**

The present invention will be described in more detail below referring to Examples. Note that the scope of the present invention is not limited by the following examples.

In the following examples, the term "parts" means "parts by weight".

[Methods of Evaluation]

Evaluations for each test sample obtained by the following examples and comparative examples were carried out by the following methods. Each evaluation was carried out by measuring 5 parts of each test sample. The results were shown in Table 1.

(1) Measurement of Hardness of Resin Film

After forming a resin film, hardness was measured by a type A measuring method specified in JIS-K-6253.

(2) Calculation of Void Ratio

The resin base material wherein a resin film is formed thereon was cut off in 10cm X 10cm, then the thickness of the film was measured to obtain an apparent volume V ($cm^3$). In addition, the weight (g) of the sample was measured to obtain a volume shared by the resin film v ($cm^3$) from the specific gravity of the solid content used in the resin film, and a volume void ratio (%) of the resin film was calculated by the following formula:

$$\text{Formula: Volume Void Ratio (\%)} = \{(V-v)/V\} \times 100$$

(3) Evaluation of Definition of Thin Line

The line width of the electroconductive thin line obtained was observed and evaluated, manufactured by Olympus Optical Co., Ltd, trade name "LEXT OLS3000".

(4) Evaluation of Film Strength

After forming a resin film, the film strength was measured by a measuring method specified in JIS-K-5600-5-1 with a mandrel of 10mm, and then the surface of the film was observed by the laser microscope to evaluate the film strength by the following criteria:

○: No cracks
×:many cracks
××:many cracks and peel-off of a film
-: unmeasurable because of no measuring objects

<Example 1>

(1) Preparation of a coating solution for forming a resin film:

8 parts by weight of a polyvinyl alcohol aqueous solution (manufactured by Sekisui Chemical Co., Ltd, trade name "S-LEC KW-1", prepared so that the solid content is 10 parts by weight) and 92 parts by weight of an aqueous solution wherein alumina having a particle diameter of 20 to 30$\mu$m is dispersed (the amount of alumina fine particles; 10% by weight) were mixed together to prepare a coating solution 1.

(2) Formation of a resin film:

The above-mentioned coating solution 1 was coated on a polyester film having the thickness of 125$\mu$m by using a die coater so that the amount of the coating solution becomes 60 g/m$^2$, and then drying process was carried out in a hot air drying machine for 2 minutes at 150˚C to obtain a resin film. The thickness of the resin film thus obtained was 6 to 7$\mu$m.

(3) Pattern Printing:

Screen printing was carried out by using a screen plate of a mesh pattern formed by thin lines of a square lattice form to prepare a printing pattern. The printing ink used here was a palladium catalyst ink. The solvent used for the palladium catalyst ink was diethyleneglycol butylether acetate. The result of a peeling test against the resin film by the above-described cross-cut method specified in JIS-K-5600-5-6 had been confirmed to be not higher than 15%. The line width of the thin line of the screen plate was 20μm and the space between a line and a line was 200μm.

(4) Formation of a metal layer by plating

After preparing a printing pattern, electroless copper plating, manufactured by OKUNO CHEMICAL INDUSTRIES CO., LTD, trade name "OPC-750 electroless copper M", was carried out. In addition, electrolytic copper plating treatment was carried out by using an electrolytic copper plating solution (copper sulfate solution) to obtain an electroconductive thin line-formed film which was a sample. The above evaluations were carried out on the sample thus obtained and the results thereof were shown in Table 1.

<Example 2>

(1) Preparation of a coating solution for forming a resin film:

12 parts by weight of a polyvinyl alcohol aqueous solution (manufactured by Sekisui Chemical Co., Ltd, trade name "S-LEC KW-1", prepared so that the solid content is 10 parts by weight) and 88 parts by weight of an aqueous solution wherein alumina having a particle diameter of 20 to 30μm is dispersed (the amount of solid content; 10 parts by weight) were mixed together to prepare a coating solution 2.

(2) Formation of a resin film:

The above-mentioned coating solution 2 was coated on a polyester film having the thickness of 125μm by using a die coater so that the amount of the coating solution becomes 60 g/m², and then drying process was carried out in a hot air drying machine for 2 minutes at 15C˚C to obtain a resin film.

(3) Pattern Printing:

Screen printing was carried out by using a palladium catalyst ink to prepare a printing pattern in a same manner as in Example 1.

(4) Formation of a metal layer by plating

Plating treatment was carried out in a same manner as in Example 1 to obtain an electroconductive thin line-formed film which was a sample. The above evaluations were carried out on the sample thus obtained and the results thereof were shown in Table 1.

<Example 3>

(1) Preparation of a coating solution for forming a resin film

100 parts by weight of a polyurethane resin, 1 part by weight of a cross-linking agent, 60 parts by weight of a MEK/toluene mixed solution wherein the mixing ratio was 1:2, and 70 parts by weight of a MEK/water mixed solution wherein the mixing ratio was 1:10, were mixed together to prepare a coating solution 3.

(2) Formation of a resin film:

The above-mentioned coating solution 3 was coated on a polyester film having the thickness of 125μm by using a doctor knife coater so that the amount of the coating solution becomes 30 g/m$^2$, and then drying process was carried out in a hot air drying machine for 1 minute at 70°C and then 1 minute for 130°C to obtain a resin film.

(3) Pattern Printing:

Gravure printing was carried out by using a gravure printing plate of a mesh pattern formed by thin lines of a square lattice form to prepare a printing pattern. The printing ink used here was an electroconductive paste. The electroconductive paste used here was a mixture of an ethylcellulose resin (8% by weight) and a solid component containing silver as electroconductivity-imparting particles (60% by weight). The solvent used here was a glycol ester type solvent and the result of a peeling test by the cross-cut method specified in JIS-K-5600-5-6 had been confirmed to be not higher than 15%. The line width of the thin line of the gravure printing plate was 20μm and the space between a line and a line was 200μm.
The above evaluations were carried out on the electroconductive thin line-formed film which was a sample thus obtained and the results thereof were shown in Table 1.

comparative Example 1>

(1) Preparation of a coating solution for forming a resin film

A coating solution 1 was prepared in a same manner as in Example 1.

(2) Formation of a resin film:

The coating solution 1 was coated on a polyester film having the thickness of 125μm by using a die coater so that the amount of the coating solution becomes 60 g/m$^2$, and then drying process was carried out in a hot air drying machine for 8 minutes at 150°C to obtain a resin film.

(3) Pattern Printing:

Screen printing was carried out by using a palladium catalyst ink to prepare a printing pattern in a same manner as in Example 1.

(4) Formation of a metal layer by plating

Plating treatment was carried out in a same manner as in Example 1 to obtain an electroconductive thin line-formed film which was a sample. The above evaluations were carried out on the sample thus obtained and the results thereof were shown in Table 1.

<Comparative Example 2>

(1) Preparation of a coating solution for forming a resin film:

5 parts by weight of a polyvinyl alcohol aqueous solution (manufactured by Sekisui Chemical Co., Ltd, trade name " S-LEC KW-1", prepared so that the solid content is 10 parts by weight) and 95 parts by weight of an aqueous solution wherein alumina having a particle diameter of 20 to 30μm is dispersed (the amount of alumina fine particles; 10% by weight) were mixed together to prepare a coating solution 4.

(2) Formation of a resin film:

The above-mentioned coating solution 4 was coated on a polyester film having the thickness of 125μm by using a die coater so that the amount of the coating solution becomes 60 g/m$^2$, and then drying process was carried out in a hot air drying machine for 2 minutes at 150°C to obtain a resin film.

(3) Pattern Printing:

Screen printing was carried out by using a palladium catalyst ink to prepare a printing pattern in a same manner as in Example 1.

(4) Formation of a metal layer by plating

Plating treatment was carried out in a same manner as in Example 1 to obtain an electroconductive thin line-formed film which was a sample. The above evaluations were carried out on the sample thus obtained and the results thereof were shown in Table 1.

<Comparative Example 3>

(1) Pattern Printing:

Screen printing was carried out on a polyester film having the thickness of 125μm wherein a resin film was not formed thereon by using a palladium catalyst ink to prepare a printing pattern in a same manner as in Example 1.

(2) Formation of a metal layer by plating

Plating treatment was carried out in a same manner as in Example 1 to obtain an electroconductive thin line-formed film which was a sample. The above evaluations were carried out on the sample thus obtained and the results thereof were shown in Table 1.

**[Table 1]**

**Table 1**

| | Resin Film | | | Line Width | | Film Strength |
|---|---|---|---|---|---|---|
| | Resin:Particles | Hardness | Void Ratio (%) | μm | Evaluation | |
| Example 1 | 1:11.5 | 47-50 | 18-20 | 25-27 | ○ | ○ |
| Example 2 | 1: 7.3 | 23-25 | 31-33 | 25-28 | ○ | ○ |
| Example 3 | - | 63-68 | 30-36 | 30-34 | ○ | ○ |
| Comparative Example 1 | 1:11.5 | 75-77 | 7-10 | 45-68 | × | × |
| Comparative Example 2 | 1:19 | 12-16 | 44-48 | 40-63 | × | ×× |
| Comparative Example 3 | - | - | - | 62-80 | × | - |

**Industrial Applicability**

According to the present invention, an electroconductive member having a high-definition electroconductive thin line free from blurring and rupture can be produced at low cost.

**Claims**

1. A method for forming an electroconductive thin line on the surface of a resin base material which comprises at least the following steps (a) and (b):

(a) a step of forming a resin film having a hardness of 20 to 70, as measured by a type A measuring method specified in JIS-K-6253 on the surface of a resin base material (a resin film-forming step),
(b) a step of forming a thin line pattern on the resin film by intaglio printing or stencil printing (a thin line pattern-forming step).

2. The method for forming an electroconductive thin line according to claim 1, wherein said step (b) is a step of forming a thin line pattern on the resin film using an electroconductive paste by intaglio printing or stencil printing.

3. The method for forming an electroconductive thin line according to claim 1, wherein said step (b) is a step of forming a thin line pattern on the resin film using an electroless plating catalyst ink by intaglio printing or stencil printing, and subsequently forming a metal layer on the thin line pattern by plating.

4. The method for forming an electroconductive thin line according to claims 1 to 3, wherein said resin film has voids in its inside.

5. The method for forming an electroconductive thin line according to claim 4, wherein a void ratio of said resin film is 10 to 40%.

6. The method for forming an electroconductive thin line according to claims 1 to 5, wherein said resin film comprises fine particles having a particle diameter of 10 to 200nm.

7. The method for forming an electroconductive thin line according to claims 1 to 6, wherein said resin film is insoluble in a solvent used for an electroconductive paste or an electroless plating catalyst ink.

**INTERNATIONAL SEARCH REPORT**

| International application No. |
| --- |
| PCT/JP2008/070530 |

A. CLASSIFICATION OF SUBJECT MATTER
*H05K3/38(2006.01)i, H05K3/12(2006.01)i, H05K3/18(2006.01)i*

According to International Patent Classification (IPC) or to both national classification and IPC

B. FIELDS SEARCHED

Minimum documentation searched (classification system followed by classification symbols)
H05K3/38, H05K3/12, H05K3/18

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 2004-296504 A  (Toshiba Corp.), 21 October, 2004 (21.10.04), Par. Nos. [0016] to [0026], [0052] to [0059], [0071] & US 2004/0191497 A1     & CN 1532926 A | 1-7 |
| A | JP 4-176193 A  (Matsushita Electric Industrial Co., Ltd.), 23 June, 1992 (23.06.92), (Family: none) | 1-7 |
| A | JP 5-295553 A  (Ibiden Co., Ltd.), 09 November, 1993 (09.11.93), Par. Nos. [0015] to [0018] (Family: none) | 1-7 |

☒  Further documents are listed in the continuation of Box C.          ☐   See patent family annex.

| | |
| --- | --- |
| * Special categories of cited documents: <br> "A"  document defining the general state of the art which is not considered   to be of particular relevance <br> "E"  earlier application or patent but published on or after the international filing date <br> "L"  document which may throw doubts on priority claim(s) or which is cited to establish the publication date of another citation or other special reason (as specified) <br> "O"  document referring to an oral disclosure, use, exhibition or other means <br> "P"  document published prior to the international filing date but later than the priority date claimed | "T"  later document published after the international filing date or priority date and not in conflict with the application but cited to understand the principle or theory underlying the invention <br> "X"  document of particular relevance; the claimed invention cannot be considered novel or cannot be considered to involve an inventive step when the document is taken alone <br> "Y"  document of particular relevance; the claimed invention cannot be considered to involve an inventive step when the document is combined with one or more other such documents, such combination being obvious to a person skilled in the art <br> "&"  document member of the same patent family |

| Date of the actual completion of the international search <br> 05 February, 2009 (05.02.09) | Date of mailing of the international search report <br> 17 February, 2009 (17.02.09) |
| --- | --- |
| Name and mailing address of the ISA/ <br>   Japanese Patent Office | Authorized officer |
| Facsimile No. | Telephone No. |

Form PCT/ISA/210 (second sheet) (April 2007)

**EP 2 224 797 A1**

**INTERNATIONAL SEARCH REPORT**

| International application No. |
| --- |
| PCT/JP2008/070530 |

C (Continuation).  DOCUMENTS CONSIDERED TO BE RELEVANT

| Category* | Citation of document, with indication, where appropriate, of the relevant passages | Relevant to claim No. |
| --- | --- | --- |
| A | JP 2007-210236 A  (Toyo Tire and Rubber Co., Ltd.), 23 August, 2007 (23.08.07), Par. Nos. [0019], [0068], [0070] (Family: none) | 1-7 |
| A | JP 7-193373 A  (Ibiden Co., Ltd.), 28 July, 1995 (28.07.95), Par. Nos. [0017] to [0028] (Family: none) | 1-7 |
| A | JP 62-207878 A  (Director General, Agency of Industrial Science and Technology, Toda Kogyo Corp.), 12 September, 1987 (12.09.87), Page 4, upper right column, lines 5 to 9 (Family: none) | 3 |
| A | JP 2001-144446 A  (Ibiden Co., Ltd.), 25 May, 2001 (25.05.01), Par. Nos. [0070] to [0071] (Family: none) | 6 |

Form PCT/ISA/210 (continuation of second sheet) (April 2007)

15

**EP 2 224 797 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004325552 A

- JP 2003145709 A